# EUROPEAN PATENT APPLICATION

(11) **EP 4 617 934 A1**
(43) Date of publication of application: **17.09.2025**
(21) Application number: 24163343.7
(22) Date of filing: 13.03.2024
(51) Int. Cl.: G06F 30/13

(54) **FIT ROOMS**

(71) Applicant: Bricsys NV, 9050 Gent (Ledeberg) (BE)
(72) Inventor: LELIEUR, Piet, 9090 Melle (BE); EKRAMI, Omid, 2600 Antwerpen (BE); ROOMS, Filip, 9050 Gentbrugge (BE); CHRISTIAENS, Bert, 9050 Gentbrugge (BE)
(74) Representative: IP HILLS NV

(57) **Abstract**

A method to reconstruct and transform a pre-existing architectural shape into a digital 3D model that can be used and processed in a computer aided design or CAD system. The method uses a point cloud acquired from the architectural shape that comprises point normal information to reconstruct a piecewise planar object that represents the architectural shape.

## Description

### Field of the Invention

The present invention generally relates to the field of CAD or computer aided design for infrastructure design and construction, i.e. the design of roads, bridges, pipelines, buildings, equipment. More specifically does it relate to the automated reconstruction of scanned data of an architectural shape into a model that can be used in CAD or computer aided design. The method uses a point cloud acquired from the architectural shape that comprises point normal information to reconstruct a piecewise planar object that represents the same architectural shape.

### Background of the Invention

The automated reconstruction of 3D models from acquired data, be it images or 3D point clouds, has been one of the central topics in computer graphics and computer vision for decades. Reconstructing the as-built architectural shape of building interiors has emerged in recent years as an important and challenging research problem. An effective approach must be able to faithfully capture the architectural structures and separate permanent components from clutter (e.g. furniture), while at the same time dealing with defects in the input data. For many applications, higher-level information on the environment is also required, in particular the shape of individual rooms.

In particular, in recent years, the widespread availability and proliferation of high-fidelity visual/3D sensors (e.g., smartphones, commodity and professional stereo cameras and depth sensors, panoramic cameras, low-cost and high-throughput scanners) has been matched with increasingly cost-effective options for large data processing (e.g., cloud and GPU-accelerated computation), as well as with novel means of visual exploration, from mobile phones to immersive personal displays.

In this context, one of the rapidly emerging sub-fields is concerned with the automatic reconstruction of indoor environments. That is, a 3D representation of an interior scene must be inferred from a collection of measurements that sample its shape and/or appearance, exploiting and/or combining sensing technologies ranging from passive methods, such as single- and multi-view image capturing, to active methods, such as infrared or time-of-flight cameras, optical laser-based range scanners, structured-light scanners, and LiDAR scanners.

Based on acquired raw data, many generic surface reconstruction methods focus on producing accurate and dense 3D models that faithfully replicate even the smallest details. These models intend to provide the most accurate representation possible of the measured surfaces that compose the input scene.

More specialized surface reconstruction methods however attempt to focus on abstracting simplified high-level structured models that optimize certain application-dependent characteristics. For example in generating or revising building information models (BIM), at least the determination of the bare architectural structure is required. Therefore, structured simplified models need to be extracted as a fundamental component of a renderable model, because measured details such as narrow spaces, windows, non-cooperative materials, and abundant clutter make the transition from the acquisition of indoor scenes to their modelling and rendering a very difficult problem.

Applying standard dense surface reconstruction approaches, which optimize for completeness, resolution and accuracy, leads to unsatisfactory results. In the indoor reconstruction context, the fundamental tasks are the discovery of structural elements, such as rooms, walls, doors, and indoor objects, and their combination in a consistent structured 3D shape and visual representation.

It is therefore an object of the invention to provide a method for reliably reconstructing and labelling general 3D architectures into simplified high-level structured models.

### Summary of the Invention

According to a first aspect, this object is achieved by a reconstruction method according to claim 1. The method reconstructs a piecewise planar object representing an architectural shape of a building interior, based on a point cloud acquired from said building interior, wherein said point cloud comprises point normal information.

The reconstruction method comprises the steps of extracting initial planar primitives from said point cloud, extending said planar primitives as infinite planes, delineating a multitude of polygonal volumes enclosed by said extended planar primitives, classifying one of said polygonal volumes as an interior volume, on condition that: the upper face of said polygonal volume has a substantially high point coverage and that the point normal directions of the points comprised in said upper face of said polygonal volume are oriented substantially in a same direction, or said polygonal volume is located below another polygonal volume that is classified as an interior volume, performing said classification on all of said polygonal volumes, and concatenating all polygonal volumes that are classified as interior volumes to form said piecewise planar object.

The method of the invention uses a point cloud as input. A point cloud is a representation of a three-dimensional space in which each point in the cloud is associated with spatial coordinates (X, Y, Z), wherein the Z-axis is the vertical axis. Each point in the point cloud may additionally be associated with surface normal information. The point cloud that is used by the method of the invention must comprise this point normal information.

In the context of 3D graphics and computer vision, a point normal is a vector perpendicular to the surface at a given point. Normal data in a point cloud provides information about the orientation or direction of the surface at each point.

The extraction of the initial planar primitives has to be understood as a step wherein the data in the point cloud is analysed, and wherein so-called planar primitives are identified or extracted. Planar primitives are geometric shapes or structures that are inherently flat, meaning they lie entirely in a single plane. These primitives are fundamental in geometry and are commonly encountered in various fields such as computer graphics, computer vision, robotics, and engineering. Planar primitives may be squares, rectangles, circles, triangles or any two dimensional shape.

In the context of the invention, the shape of the planar primitives that are sought after ideally fit the objects that will be present in the output of the algorithm; i.e. rectangles which correspond to walls, floors or roof elements. In other words, the extraction step identifies initial planar primitives by means of the identification of groups of a preferably high number of points in the point cloud that lie entirely in a single plane. Certain selection criteria may be applied to determine when a collection of points in the point cloud are considered as a valid planar primitive. For instance a minimal point density of the collection of points that establish a planar primitive may be defined, or a minimal absolute or relative number of points of the point cloud contributing to the planar primitive may also be considered. The orientation of the planar primitive may also be considered to accept or reject it as a valid initial planar primitive candidate by considering its orientation; a high preference for planar primitives with pure horizontal or pure vertical orientations is obvious.

The identification of the planar primitives allows to identify all candidate object surfaces that are present in the point cloud. Some of the planar primitives can be attributed to undesired surfaces or clutter, but nevertheless will be taken up in the method.

The extraction subsequently allows that the identified planar primitive is processed in the next step of the process, which is the extension of the planar primitive into an infinite plane. In other words, the plane defining the orientation of the planar primitive is extended in all directions to form an infinite plane. This process is performed for all initial primitives, such that a collection of infinite planes is available that are intersecting with each other.

The effect of this step is that it is ensured that all candidate orientations are taken into consideration, and that based on the extraction and extension of the planar primitives a sufficient number of cells or polygonal volumes can be defined corresponding to the complexity of the scanned interior. In other words, when more planes are defined, more polygonal volumes or cells will be delineated in the next step.

In a next step, a multitude of polygonal volumes is identified by means of delineating all polygonal volumes or cells that are enclosed by the intersecting extended planar primitives or infinite planes. The collection of infinite planes are intersecting each other and as a result enclose a multitude of polygonal volumes.

The multitude of polygonal volumes or cells are, in a next step, classified as either representing a portion of the interior volume of the architectural shape, or else not to belong to the interior volume of the architectural shape. Since the method eventually reconstructs a representation of an architectural shape of a building interior, the classified polygonal volumes of interest are the ones which are classified as representing a portion or part of the interior volume. The polygonal volumes not classified as such are discarded in the subsequent steps.

The outcome of the classification is positive (i.e. the polygonal volume is considered part of the interior volume) if any of the following two conditions is met.

The first condition by which a polygonal volume may be considered to be part of the interior volume is when the upper face of a considered polygonal volume has a substantially high point coverage and that the point normal directions of the points comprised in said upper face of said polygonal volume are oriented substantially in a same direction. The point normal directions are in the context of the invention considered to be oriented substantially in the same direction when they do not deviate more then 15°, and more preferably not more then 10°, from the mean direction of the points contributing to the upper face of the polygonal volume. More specifically should the point normal directions have a downward directional component.

The upper face of the considered polygonal volume is the face or are the faces of the polygonal volume that is or are oriented upward in the direction of the vertical Z-axis of the building or building interior. In fact the method starts to scan downwards through all delineated cells starting from the upper-most cells, and then tries to determine the "highest surface" or upper face of the cell or polygonal volume. In case that there is more then one upper face present in said polygonal volume, all upper faces are considered. A cell or polygonal volume is then considered to be part of the interior volume is when the upper face of a considered cell or polygonal volume has a substantially high point coverage.

The point coverage of a point cloud refers to the density or distribution of points within the cloud relative to the area or volume it represents. Essentially, it describes how well the point cloud captures the details and features of the scanned object or scene. Achieving adequate point coverage often depends on various factors, including the sensor used for data acquisition, the scanning technique employed, the resolution settings, and the characteristics of the scanned object or environment. Overall, understanding the point coverage of a point cloud is essential for assessing its quality and suitability for specific applications, as it directly impacts the accuracy and level of detail in the reconstructed 3D representation.

A substantially high point coverage refers in the context of the invention to the amount of points per unit area that provide the statistical certainty that the considered face is indeed part of a wall, roof or floor of the interior volume. The point coverage is calculated from the initial extracted planar primitives. It is defined by the amount of overlap between the planar primitive and the face of the cell which was formed by slicing with the infinite plane corresponding to the planar primitive. Preferably, a threshold of 30% is used for the first step where we scan downwards through the multitude of polygonal volumes or cells until a face is encountered with such high point coverage.

The second possible condition by which a polygonal volume may be considered to be part of the interior volume is when the considered polygonal volume is located below another cell or polygonal volume that is classified as an interior volume. This second condition is met when a considered polygonal volume is located underneath (in the Z-direction) another cell or polygonal volume that already is classified as representing a portion of the interior volume of the architectural shape by meeting the first condition.

The above classification step is performed on all delineated cells or polygonal volumes. The classification of the cells is performed preferably in a vertically downward direction, such that the cells that are located in the highest positions are classified before the lower located cells, such that as soon as a polygonal volume is classified as being part of the interior volume of the architectural shape, all lower located polygonal volumes can be classified as such efficiently based on the second condition described above.

In a final step, all polygonal volumes that are classified as interior volumes are concatenated to form a piecewise planar object that represents the room solid. The room solid is the final solution or result of the reconstruction method, and is a volume that represents the internal volume of the detected room. A piecewise planar object refers to a three-dimensional object or surface that is composed of individual planar regions, where each region is flat or nearly flat. In other words, the overall object can be approximated or represented as a collection of interconnected planar surfaces. The term piecewise indicates that the object is divided into distinct pieces or segments, and planar indicates that each of these pieces is flat.

The advantage of representing an object as a piecewise planar structure is that it simplifies the mathematical and computational modelling of complex surfaces. It allows for the approximation of more intricate shapes using a combination of simpler planar elements. This representation is often used in various applications, such as 3D modelling, computer-aided design, computer graphics, and computer vision. Piecewise planar models are particularly useful when dealing with surfaces that exhibit a degree of smoothness and continuity but can be broken down into relatively simple planar patches. This approach can be employed in algorithms for surface reconstruction, rendering, and other geometric processing tasks. It's important to note that the approximation may introduce some error, especially for highly curved or nonplanar surfaces. However, for many practical applications, piecewise planar representations strike a balance between accuracy and computational efficiency.

The method of the invention therefore is advantageous in that it provides a reliable and fast way to construct a high-level structured 3D object of the interior of the building interior of which the interior surface was scanned by a 3D scanning method known in the art. The advantage of the method is that the process of expanding the initial planar primitives into infinite planes which then form polygonal volumes allow to reliably compensate for any missing data of unscanned surface portions such that the resulting reconstructed result still reliably represents the high-level abstraction of the building interior. The method also allows to separate permanent components from clutter in the measurement data.

In a second embodiment of the invention, the extraction of said initial planar primitives from said point cloud is more specifically performed by detecting a set of initial planar segments *S*={*s*ᵢ} from the point cloud *P,* wherein each initial planar segment *S* is defined as a collection of points *sᵢ* whose point normal directions are substantially identical, and each of said points *sᵢ* cannot be assigned to more then one plane.

In the context of the invention, when point normal directions are substantially identical, their direction do not deviate more then 15°, and more preferably not more then 10°. The advantage of this approach is that an initial planar segment *S* can be identified by a number of points in the point cloud that share the same normal direction. This may be an alternative approach compared to a detection of points of which the coordinates lay in the same plane. Moreover when the points cannot be assigned to more then one plane, they are excluded from a selection in another plane.

In a third embodiment of the invention, the extraction of said initial planar primitives from said point cloud is more specifically performed by detecting initial planar segments *S*={*s*ᵢ} from the point cloud *P,* wherein each initial planar segment *S* is defined as a collection of points *sᵢ* whose distances are smaller than a threshold *t* to said planar segment *S,* and each of said points *sᵢ* cannot be assigned to more then one plane.

In this embodiment, the approach to determine whether a point lays in the same plane is determined by calculating the perpendicular distance from between the point and the plane, and determining that a point indeed lays in a plane on condition that the perpendicular distance does not exceed a threshold *t.* The threshold can then be determined by a user or a preset value.

In a further embodiment, a polyhedron is drawn around said point cloud volume as a calculation boundary such that the faces of said polyhedron contribute to said initial planar primitives. The advantage of this additional step is that an additional and well determined outer boundary is added to the collection of initial planar primitives delineating a calculation boundary that determines the volume that comprises all polygonal volumes that are taken into consideration.

In yet another embodiment of the invention, a calculation boundary is determined that is based on a room floor definition. The detection of the room floor may be obtained through methods that may be automated or rely on user input.

In yet another preferred embodiment, the detected planar primitives may be further optimized based on domain knowledge features. In this case the detected planar primitives may be adjusted, corrected in their orientation or even omitted based on certain domain knowledge features. For example, planar primitives that can be positively associated à priori with room walls may be adjusted to be 100% vertically oriented in space, since it may be assumed that any walls in the room are supposed to be completely vertical. For instance, may the orientation of connecting walls that are arranged under nearly 90° be assumed to be arranged under exactly 90°. Another example may be, that planar primitives that appear to represent a room floor may be considered to be oriented fully horizontally. Many other examples may be taken into consideration.

In yet another preferred embodiment, additional initial planar primitives may be added based on domain knowledge features. It is therefore possible to strengthen the performance of the algorithm by selectively adding planes that generate additional polygonal volumes for the calculation. For instance may vertical planes be added in locations where vertical walls are expected.

In yet another embodiment, may the results be further refined by removing a polygonal volume that is classified as an interior volume at an edge of said piecewise planar object, resulting in an updated piecewise planar object, on condition that said updated piecewise planar object has a higher point coverage than the original piecewise planar object.

This additional step is a further optimization of the method, wherein the point coverage of the final piecewise planar object is compared to the point coverage of the final piecewise planar object comprising a small improvement. The small improvement may either consist of an addition of a polygonal volume or the removal of a polygonal volume to the piecewise planar object. The additional step therefore optimizes the piecewise planar object such that it comprises the highest possible point coverage.

The embodiments of the systems and methods described herein may be implemented in hardware or software, or a combination of both. However, preferably, these embodiments are implemented in computer programs executing on programmable computers each comprising at least one module component which comprises at least one processor (e.g. a microprocessor), a data storage system (including volatile and non-volatile memory and/or storage elements), at least one input device, and at least one output device. For example and without limitation, the programmable computers (referred to here as computer systems) may be a personal computer, laptop, personal data assistant, and cellular telephone, smart-phone device, tablet computer, and/or wireless device. Program code is applied to input data to perform the functions described herein and generate output information. The output information is applied to one or more output devices, in known fashion.

Each program is preferably implemented in a high level procedural or object oriented programming and/or scripting language to communicate with a computer system. However, the programs can be implemented in assembly or machine language, if desired. In any case, the language may be a compiled or interpreted language. Each such computer program is preferably stored on a storage media or a device (e.g. ROM or magnetic diskette) readable by a general or special purpose programmable computer, for configuring and operating the computer when the storage media or device is read by the computer to perform the procedures described herein. The subject system may also be considered to be implemented as a computer-readable storage medium, configured with a computer program, where the storage medium so configured causes a computer to operate in a specific and predefined manner to perform the functions described herein.

The present invention can be implemented as a computer program product adapted to carry out the steps as set out in the description. The computer executable program code adapted to carry out the steps set out in the description can be stored on a computer readable medium.

Specific examples and preferred embodiments are set out in the dependent claims. Further advantages and embodiments of the present invention will become apparent from the following description and drawings.

### Brief Description of the Drawings

Fig. 1 shows a flowchart of the method of the invention, depicting the different method steps;
Fig. 2 is an illustration of a point cloud of one floor of a building on which a polyhedron 204 is superimposed, and which is intersected by multiple extensions of initial planar primitives;
Fig. 3 is an illustration of a polyhedron that is defined around the point cloud (not visible) and that is intersected by a multitude of extended planar primitives 103 and thereby forming a multitude of polygonal volumes 104;
Fig. 4 is an illustration of the polygonal volumes that are classified as an interior volume because the upper face of the polygonal volume has a substantially high point coverage and of which the point normal directions of the points comprised in the upper face of the polygonal volume are oriented substantially in a same direction, and which are represented by a shading in the drawing;
Fig. 5 is an illustration of the polygonal volumes that are removed from an edge of the detected interior volume; based on a higher resulting point cloud coverage of the interior volume; the polygonal volumes for removal are marked by a shading;
Fig. 6 is an illustration of the obtained interior volume after removal of the polygonal volumes indicated in Fig. 5
Fig. 7 is an illustration of the polygonal volumes that are added at an edge of the detected interior volume; based on a higher resulting point cloud coverage of the interior volume; the polygonal volumes that are added are marked by a shading;
Fig. 8 is an illustration of the final result representing different building interiors (or rooms) by a piecewise planar object for each room.

### Detailed Description of Embodiment(s)

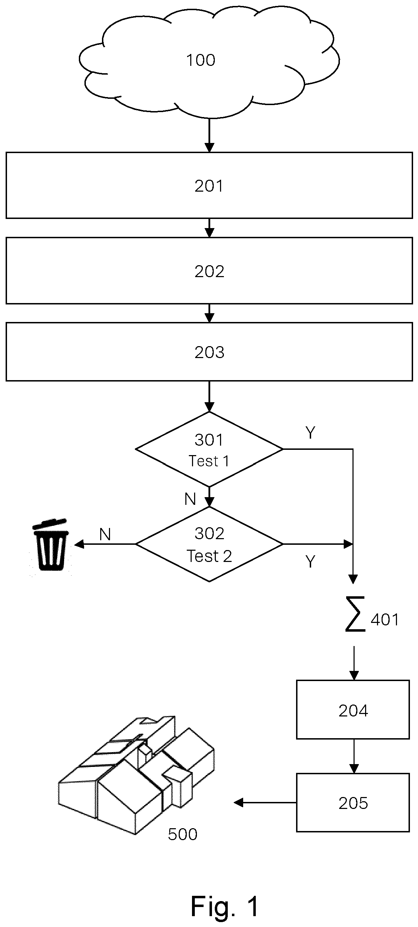

Fig.1 is a flowchart that gives an overview of the steps of the method of the invention. The steps of the method may be executed in a CAD software. CAD (Computer-Aided Design) software is designed to handle a variety of geometric primitives and shapes, including planes, lines, curves, and solids. CAD software allows users to create, modify, analyse, and visualize 2D and 3D models for various engineering, architectural, and design purposes.

In CAD software, users can create planes as reference surfaces or as elements of geometry. These planes can be used as the basis for sketching or modelling other geometric features. Geometric primitives such as points, lines, circles, ellipses, arcs, and splines are fundamental building blocks in CAD modelling. Users can create and manipulate these primitives to define the basic shapes and features of their designs.

Additionally, CAD software supports more complex geometric shapes such as surfaces and solids. Users can create surfaces by defining boundaries, curves, or by lofting between existing geometry. Solids can be created by combining surfaces or by extruding, revolving, or sweeping 2D profiles.

CAD software provides tools for precise manipulation, measurement, analysis, and visualization of geometric entities, allowing designers and engineers to create detailed and accurate models for a wide range of applications.

Therefore, the steps in the method of the invention are preferably performed in a CAD system. The input data that are required for the reconstruction method of the invention is a point cloud 100. The input data is a point cloud of a building interior, which may be the point cloud of the interior of a room, or a collection of rooms. The point cloud is sampled from a real-world environment that could be captured by various means (e.g., drones, handheld scanners, lidar systems and depth cameras) and which are enriched with their point normal data.

As an example, a point cloud 100 obtained by a lidar system typically comprises coordinate data (x, y, z) representing the 3D positions of points in space. However, to include point normal data, additional information about the orientation or direction of each point's surface normal is also captured. The lidar system emits laser pulses and measures the time it takes for the pulses to bounce back from objects in the environment. By measuring the time-of-flight and angles of the returning pulses, the system can calculate the 3D positions of points in space (x, y, z coordinates).

The point cloud 100 that is used by the method of the invention must comprise point normal information. In case that the point cloud does not intrinsically comprise the point normal information yet, this may be derived and estimated for each point of the point cloud data by means of a normal estimation algorithm.

Several techniques can be employed to estimate the surface normal at each point in the point cloud. Common methods include so-called local methods that estimate normals based on the points in the vicinity of each point. Examples include the k-nearest neighbours algorithm or moving least squares (MLS) fitting. Alternatively, so-called global methods may be used that consider the entire point cloud to estimate normals. Principal Component Analysis (PCA) is a common global method used for normal estimation. Another method that can be applied is a curvature-based method which uses curvature information to infer normal vectors.

The resulting point cloud 100 of which each point in the cloud is associated with both spatial coordinates (X, Y, Z) and surface normal information is used as input for the method of the invention.

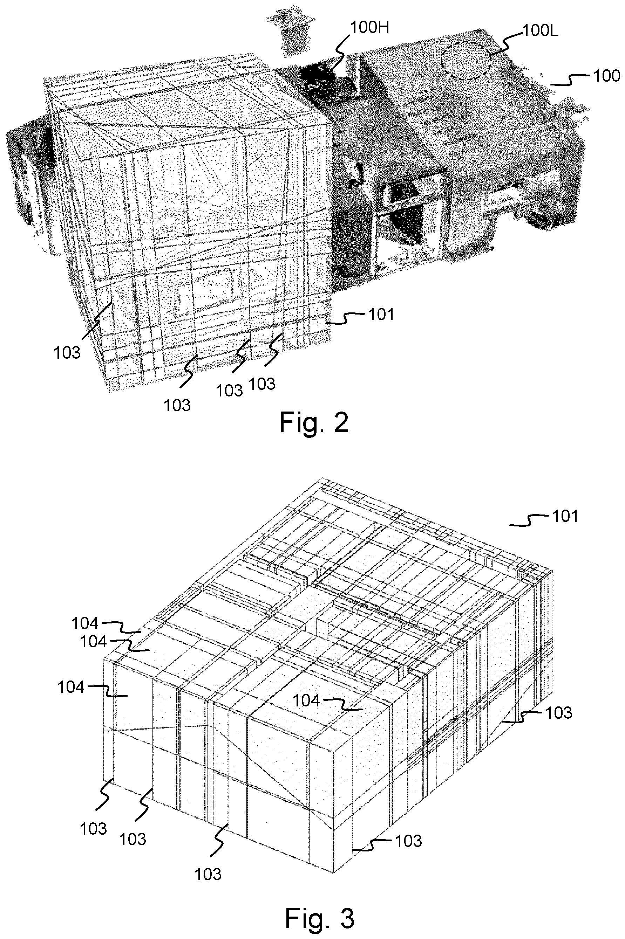

In Fig. 2 a 3D projection of a point cloud 100 of the interior measurements of one floor of a building is given. The differences in pixel densities attempt to represent the point cloud densities in their measured locations. In other words, the different pixels that are visible of point cloud 100 represent the individual points from the point cloud; in darker areas 100H of the point cloud with high pixel density a high number of pixels per unit area are measured, whereas in lighter areas 100L of the point cloud with lower density, the point cloud density is lower.

Reverting to Fig. 1, as a first step 201 in the algorithm, high-quality instances of basic geometric primitives (e.g., squares, rectangles, triangles or circles) need to be extracted from the acquired point cloud, and preferably stored in the CAD model. This is achieved in a first instance by means of detecting and identifying plane patches in the point cloud, which are planar areas of which the points share a same normal direction. Since the point cloud measurements are typically corrupted by noise and outliers due to imperfections of the scanning technology, it is necessary to apply some kind of filtering during the extraction of the initial planar primitives in order to obtain high-quality instances of basic geometric primitives.

In the described method only planar geometric components are considered as initial geometric primitives. A common approach for extracting planar primitives is to apply a Random Sample Consensus (RANSAC) algorithm to the point cloud. In order to detect a set of initial planar segments *S* = {*sᵢ*} from the point cloud *P,* a collection of points *sᵢ* is detected whose normal directions point are (almost) identical. The detection here is performed based on similarities between neighbouring points in the point cloud sharing the same normal direction.

Alternatively, or as a further improvement step, a collection of points *sᵢ* is detected whose distances are smaller than a threshold *t* to a plane, and each of the points cannot be assigned to no more then one plane. The latter step can be used to provide a more accurate set of initial planar primitives. In this case, the detection is based on the relative distances of candidate points in the point cloud that are located in a same plane.

Note that any type of object that was present during the measurement but that is not necessarily part of a wall, floor or ceiling will give rise to the presence of a primitive that eventually will not part of the final solution itself. These primitives should not be part of the final solution but will nevertheless be part of the input for the next step of the algorithm. Because of this, a number of the detected initial planar primitives may be attributed to undesired surfaces or clutter. In the subsequent steps, these surfaces will however be filtered out or removed.

Further optimisations can be applied immediately after detecting the initial planar primitives, and this by adjusting for instance the exact orientations of the detected planar primitives to match the expected orientations and angles of certain high-level structured objects, such as walls or ceilings. For instance, in case that an initial planar primitive shows a small inclination angle that is off the expected inclination for a wall by for instance 0,5°-1°, the inclination angle for the initial planar primitive may be adjusted or snapped to the expected value for a wall. These optimisations may under certain conditions provide an improved end result.

In a next step 202 of the method, and starting from the collection of multiple initial planar primitives that are preferably stored in the CAD system, will the initial planar primitives be extended as infinite planes 103 in all directions. In order to keep the CAD model manageable, a calculation boundary may be defined to limit the size of the 3D model. This calculation boundary may be defined as a bounding polygon 101 such as depicted in Fig. 2 which at least encompasses the entire volume of the scanned architectural shape and is intersected by the multitude of extended planes 103 that are based on the earlier defined initial planar primitives of step 201. In Fig. 2 the bounding polygon 101 encloses the space of a single room or interior.

The calculation boundary may be partially defined by calculating a floor definition of the scanned room based on a room floor detection method. A vertical projection of the points of the point cloud may already give a good indication of the floor contour. The calculation boundary may then be selected to at least vertically enclose the floor surface.

Another example of such a bounding polygon 101 is given in Fig.3. In Fig. 3 the bounding polygon 101 encloses a number of rooms or interiors which each generate their own set of extended planes 103.

In a further step 203 of the method, a cell complex is created of which the cells 104 are composed by the detected extended planes 103 and which serve as cell boundaries. The cells 104 consist of a set of polygonal volumes 104 that completely occupies the bounding polygon 101. The polygonal volumes 104 may be stored in the CAD system as CAD objects.

In the next steps 301 and 302 of the method a classification is performed on all the polygonal volumes 104 preferably starting with the volumes 104 that are positioned in the highest end or top side of the 3D model. The classification is based on two tests that determine whether or not a polygonal volume 104 is part of the interior volume of a room.

A first test 301 determines if the upper face of a polygonal volume 104 has a substantially high point coverage and that the point normal directions of the points comprised in the upper face of the polygonal volume are oriented substantially in a same direction. In other words, when selecting an untested polygonal volume 104 from the top of the stack of all polygonal volumes, its upper face is tested to determine if it has a substantially high point coverage, meaning that a significant number of points from the point cloud were attributed to this upper face. If the test is positive, then it can be assumed that this upper face is probably part of the ceiling plane of the room.

It should be appreciated that the threshold that determines whether or not the point coverage is substantially high or not, is preferably expressed as an error margin between the measured point density for the upper face surface considered, and the estimated point density for the same upper face surface. This estimated point density may be calculated from the total number of points in the point cloud, and the estimated surface and location of the upper face from the point cloud detector. This predetermined error margin being no more than 20%, preferably no more than 10% and more preferably no more than 5%.

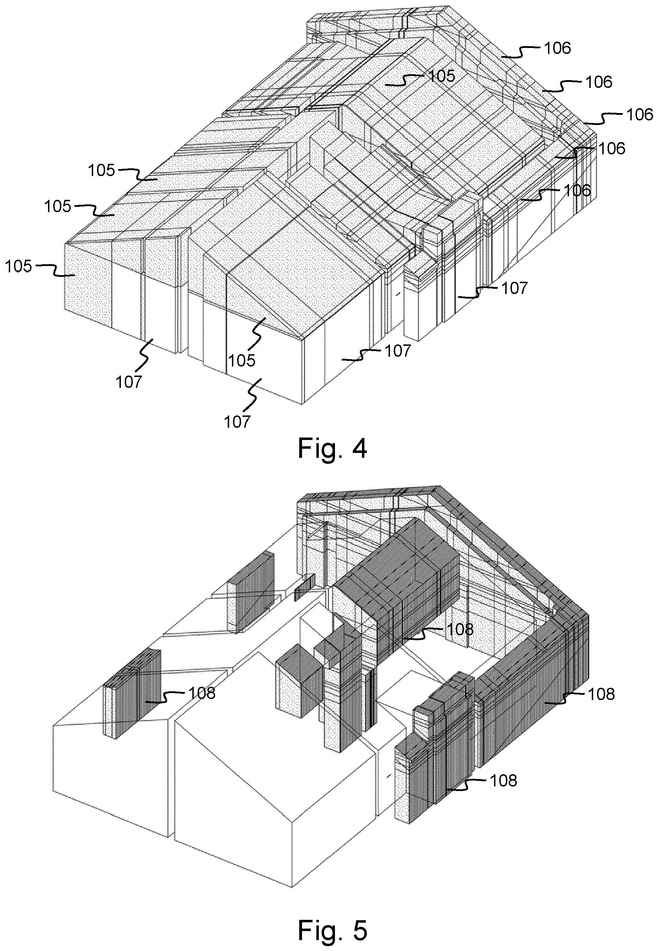

The classification preferably starts by performing the first test 301 from the highest located polygonal volumes 104 in the boundary volume in the assumption that these highest cells will not be part of the room interior. By progressively examining all cells layers from top to bottom, i.e. by peeling off the highest cells, the portions of the scanned ceiling plane will start to appear when the polygonal volumes with an upper face meeting the classification criteria are identified. The result of this process is illustrated in Fig. 4, wherein the positively classified cells 105 are represented with a pattern. The result is that that all polygonal volumes that share their upper face with a ceiling plane will be identified. Errors may occur as false positives 106 or false negatives. Further steps in the process will however filtered these out.

When the classification step 301 is completed, the next classification step 302 positively identifies all polygonal volumes 107 that are positioned vertically under any of the previously positively classified cells 105 in step 301 as being part of the interior volume of the room. This is illustrated in Fig.4, where the white cells 107 are positively classified as being part of the interior volume of the room. The result of the classification steps 301 and 302 is a set of polygonal volumes. When concatenating this set, the result 401 is a volume that represents a rough estimation of the interior volume of the room. The outside surface of this volume may be represented as a piecewise planar object, which then may be easily stored and processed in a CAD system.

Further optimizations may be applied to the above result 401 that was mainly obtained from a vertical perspective on the point cloud data. After all, only the upper faces were considered in building up the results.

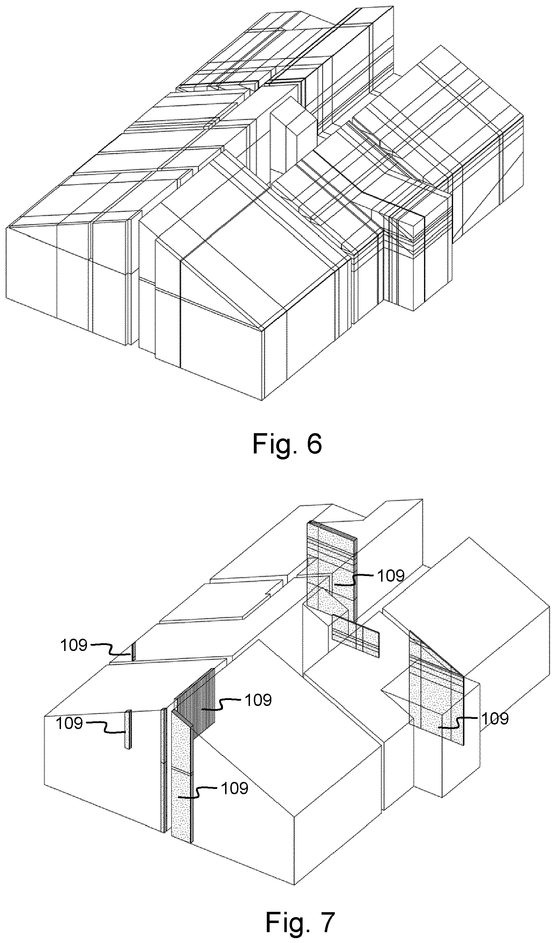

A first optimization 204 concerns the detection and removal of any polygonal volumes that may be considered as false positive results produced by the method so far. In this first optimization step, all polygonal volumes that have an exterior face or a surface that is not covered by a neighbouring polygonal volume, are removed one by one from the previous result 401 to test whether their removal from the previous result results in a piecewise planar object that has a higher point coverage than the original piecewise planar object. In case that the removal of the polygonal volume in question results in a piecewise planar object with a higher point coverage, it is assumed that the overall result is better. In this case the removed polygonal volume remains effectively removed from the end solution. Fig. 5 illustrates the selection of the polygonal volumes 108 that are removed from the solution represented in Fig. 4 and obtained in the previous step. The obtained result after the removal of said polygonal volumes 108 is shown in Fig. 6.

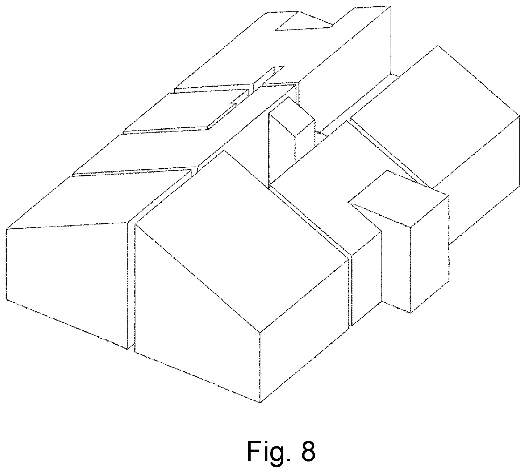

A second optimization 205 then the detection and addition of any polygonal volumes that may be considered as false negative results produced by the previous steps. In this second optimization step, all polygonal volumes that have an exterior face or a surface that is not covered by a neighbouring polygonal volume, are added one by one from the previous result to test whether their addition from the previous result results in a piecewise planar object that has a higher point coverage than the original piecewise planar object. In case that the addition of the polygonal volume in question results in a piecewise planar object with a higher point coverage, it is assumed that the overall result is better. In this case the added polygonal volume remains effectively removed from the end solution. Fig. 7 illustrates the selection of the polygonal volumes 109 that are added to the solution represented in Fig. 6 and obtained in the previous step. The obtained result after the addition of said polygonal volumes 109 is shown in Fig. 8, and represents the final optimized result 500.

The method of the invention may be executed as a CAD model, meaning that as soon as the point cloud data are converted into initial planar primitives, they are stored and further processed by the method as a collection of CAD objects. Geometric objects such as primitives, planes and alike are very suitable to be processed as a CAD model. The steps of the method of the invention, can be executed as CAD operations; for instance, an initial planar primitive can be extended into planes within the boundaries of a certain calculation limit. As such may a data set that represents a physical structure in the real world be converted and modelled into a CAD model such that this model can be further processed and manipulated in a computer.

However all method steps described above serve a technical purpose by their application to a specific technical problem that occurs in a field of technology of converting scanned data into a 3D model. In order to construct infrastructure, it is typically necessary to design the infrastructure using CAD models composed of CAD objects that represent a planned modification to an infrastructure. As part of the design process, it is often desirable to determined how the planned modifications will interact and fit with the existing conditions of the infrastructure or building.

Existing conditions at a site are commonly modelled by a special type of model produced from photographs of the site by an automated software process, referred to as a 3D reality model. There are various commercial products on the market which produce 3D reality models of existing conditions at a site.

However, a technical problem arises in that CAD objects of a CAD model of planned infrastructure cannot be readily integrated into a 3D reality model of existing site conditions. That is, combining CAD objects of planned infrastructure and a 3D reality model of existing site conditions is non-trivial from a technical standpoint.

The method addresses this problem by reconstructing a model of the existing conditions of the infrastructure or building such that this model may be fully integrated with the planned modifications, or may be used as a starting point to plan the modifications.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein. In other words, it is contemplated to cover any and all modifications, variations or equivalents that fall within the scope of the basic underlying principles and whose essential attributes are claimed in this patent application. It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

The embodiments of the systems and methods described herein may be implemented in hardware or software, or a combination of both. However, preferably, these embodiments are implemented in computer programs executing on programmable computers each comprising at least one module component which comprises at least one processor (e.g. a microprocessor), a data storage system (including volatile and non-volatile memory and/or storage elements), at least one input device, and at least one output device. For example and without limitation, the programmable computers (referred to here as computer systems) may be a personal computer, laptop, personal data assistant, and cellular telephone, smart-phone device, tablet computer, and/or wireless device. Program code is applied to input data to perform the functions described herein and generate output information. The output information is applied to one or more output devices, in known fashion.

Each program is preferably implemented in a high level procedural or object oriented programming and/or scripting language to communicate with a computer system. However, the programs can be implemented in assembly or machine language, if desired. In any case, the language may be a compiled or interpreted language. Each such computer program is preferably stored on a storage media or a device (e.g. ROM or magnetic diskette) readable by a general or special purpose programmable computer, for configuring and operating the computer when the storage media or device is read by the computer to perform the procedures described herein. The subject system may also be considered to be implemented as a computer-readable storage medium, configured with a computer program, where the storage medium so configured causes a computer to operate in a specific and predefined manner to perform the functions described herein.

The present invention can be implemented as a computer program product adapted to carry out the steps as set out in the description. The computer executable program code adapted to carry out the steps set out in the description can be stored on a computer readable medium.

## Claims

1. Reconstruction method of a piecewise planar object representing an architectural shape of a building interior, based on a point cloud *P* acquired from said building interior, wherein said point cloud *P* comprises point normal information, comprising the steps of:
extracting initial planar primitives from said point cloud,
extending said planar primitives as infinite planes,
delineating a multitude of polygonal volumes enclosed by said extended planar primitives,
classifying one of said polygonal volumes as an interior volume, on condition that:
the upper face of said polygonal volume has a substantially high point coverage and that the point normal directions of the points comprised in said upper face of said polygonal volume are oriented substantially in a same direction, or
said polygonal volume is located below another polygonal volume that is classified as an interior volume,
performing said classification on all of said polygonal volumes, and
concatenating all polygonal volumes that are classified as interior volumes to form said piecewise planar object.

2. The method of Claim 1, wherein extracting said initial planar primitives from said point cloud is performed by the steps of:
detecting initial planar segments *S*={*sᵢ*} from the point cloud *P,* wherein each initial planar segment *S* is defined as a collection of points *sᵢ* whose point normal directions are substantially identical, and each of said points *sᵢ* cannot be assigned to more then one plane.

3. The method of Claim 1, wherein extracting said initial planar primitives from said point cloud is performed by the steps of:
detecting initial planar segments *S*={*sᵢ*] from the point cloud *P,* wherein each initial planar segment *S* is defined as a collection of points *sᵢ* whose distances are smaller than a threshold *t* to said planar segment *S,* and each of said points *sᵢ* cannot be assigned to more then one plane.

4. The method according any of the preceding claims, further comprising the initial step of:
defining a polyhedron around said point cloud volume as a calculation boundary such that the faces of said polyhedron contribute to said initial planar primitives.

5. The method according any of the preceding claims, further comprising the step of defining a calculation boundary that is based on a room floor definition.

6. The method according any of the preceding claims, further comprising the step of optimizing said initial planar primitives based on domain knowledge features.

7. The method according any of the preceding claims, further comprising the step of adding supplementary initial planar primitives based on domain knowledge features.

8. The method according any of the preceding claims, further comprising the steps of
removing a polygonal volume that is classified as an interior volume at an edge of said piecewise planar object, resulting in an updated piecewise planar object,
on condition that said updated piecewise planar object has a higher point coverage than the original piecewise planar object.

9. The method according any of the preceding claims, further comprising the steps of
adding a polygonal volume that is not classified as an interior volume at an edge of said piecewise planar object, resulting in an updated piecewise planar object,
on condition that said updated piecewise planar object has a higher point coverage than the original piecewise planar object.

10. The method according any of the preceding claims, wherein said classification is performed starting from the highest located polygonal volumes of the building interior.

11. A data-processing apparatus comprising means for carrying out the method of any one of the preceding claims.

12. A computer program product comprising instructions which, when the program is executed by a computer, cause the computer to carry out the method of any one of the preceding claims.

13. A computer readable medium comprising instructions which, when the program is executed by a computer, cause the computer to carry out the method of any one of the preceding claims.
